# FASCICULE DE BREVET EUROPEEN

(11) **EP 2 309 833 B1**
(45) Date de publication et mention de la délivrance du brevet: **08.07.2015**
(21) Numéro de dépôt: 10187067.3
(22) Date de dépôt: 08.10.2010
(51) Int. Cl.: H05K 7/20

(54) **Module pour armoires informatiques et leur installation**
Module für Netzwerk- und Serverschränke, und ihr Einbau
Module for IT cabinets and installation thereof

(30) Priorité: 09.10.2009 FR 0904840
(43) Date de publication de la demande: 13.04.2011
(73) Titulaire: IP Energy, 13120 Gardanne (FR)
(72) Inventeur: Febvre, Rémy, 13109 Simiane Collongue (FR)
(74) Mandataire: Hirsch & Associés

(56) Documents cités:
- US-A1- 2009 014 397
- US-A1- 2009 190 307
- US-A1- 2009 239 460
- US-B1- 7 430 118

## Description

La présente invention concerne un module permettant de refroidir les armoires informatiques, appelées racks dans des salles machines informatiques. Le module peut en outre distribuer les courants forts permettant d'alimenter les machines et supporter le câblage réseau (courant faible) permettant de connecter les machines reçues dans les racks à un système d'informations de l'organisation.

Les machines reçues dans les racks, peuvent être des serveurs et/ou autres équipements informatiques. Les machines produisent plus ou moins de chaleur en fonction de leur utilisation. Cette chaleur est évacuée par des ventilateurs à l'intérieure des machines afin d'éviter leur surchauffe qui engendre leur détérioration prématurée et leur arrêt automatique lorsque celle-ci devient trop importante. La majorité des machines aspirent de l'air par l'avant du rack et rejettent de l'air réchauffé par l'arrière du rack avec un flux avant / arrière, mais pour certaines machines, le flux est latéral, de droite à gauche du rack ou inversement.

Pour réduire la température à l'intérieure des machines, la salle machine est climatisée par des groupes de climatisation.

Une installation des salles machines consiste à distribuer de l'air refroidi par des groupes de climatisation dans un faux-plancher doté de bouches de distribution situées devant les racks. L'air refroidi est alors aspiré par les machines du rack et est rejeté directement dans la salle. Les groupes de climatisation refroidissent cet air tiède (air réchauffé par les machines mélangé avec l'air de la salle) et rejettent l'air refroidi dans le faux-plancher. Ce même faux-plancher est utilisé par ailleurs pour distribuer les câbles de courant fort et d'informatique. Les problèmes de ce type d'installation sont multiples et engendrent une inadéquation de plus en plus prononcée avec les contraintes actuelles ; On peut notamment citer :
- faible efficacité du refroidissement lié d'une part au mélange entre les flux d'air refroidi et les flux d'air réchauffé par les machines générant par ailleurs des surconsommations énergétiques importantes,
- difficulté de la circulation d'air dans les faux-planchers, due aux différents câblages qui gênent le fonctionnement correct de la climatisation en perturbant la circulation d'air,
- incapacité à générer des puissances de refroidissement importantes, pourtant indispensables dans le cadre des technologies actuelles (blade serveurs, virtualisation...),
- manque d'évolutivité des salles machines construites (extensions du nombre de racks dans les salles machines) imposant une construction d'un plancher
de taille supérieure aux besoins initiaux pour conserver une capacité d'augmentation du nombre de racks, ce qui entraîne des coûts supérieurs et une augmentation très nette de la consommation énergétique,
- difficulté d'adaptation ou/ et de régulation de la puissance de refroidissement en fonction des besoins réels (nombre de machines), d'où une nécessité de refroidissement global plus important que nécessaire générant des surcoûts d'investissement et d'exploitation,
- difficulté d'accès aux différents câbles dans le sous-plancher,
- solidité de la structure de faux-plancher en cas de séisme et en cas de mauvaise exploitation,
- coût élevé.

Il est connu à ce jour des installations permettant de pallier à une partie de ces problématiques. Il s'agit notamment des installations comprenant des systèmes de confinement d'allées froides et d'allées chaudes conservant le principe du faux-plancher ou pour certains, intercalant des groupes de climatisation entre les racks informatiques. Il est également connu du document US 7,430,118 B1 un système de refroidissement d'un data center dans lequel un ensemble de racks est refroidi par un module de refroidissement disposé au-dessus des racks.

Il existe donc un besoin d'une installation permettant de répondre au moins partiellement aux critères précédemment cités.

A cette fin, la présente invention propose un module destiné à former conjointement avec d'autres modules identiques au moins un conduit de circulation d'air par agencement des modules sur le dessus des armoires informatiques d'une ou deux rangées, l'au moins un conduit de circulation d'air formé étant prévu pour s'étendre selon la direction de la longueur de la ou des rangées d'armoires informatiques, les armoires informatiques ayant des dimensions extérieures standardisées, lequel module présente une profondeur entre l'avant et l'arrière du module et une largeur entre deux côtés du module permettant d'assembler les modules en enfilade selon leur profondeur sur le dessus des armoires informatiques d'une rangée avec au moins un des deux côtés des modules s'étendant par-delà la largeur de cette rangée d'armoires informatiques, dans lequel le module comprend une ouverture débouchant sur le dessous du module, le conduit de circulation d'air formé par aboutement de modules identiques assemblés en enfilade selon la longueur d'une rangée ou de deux rangées côte à côte d'armoires informatiques permettant d'envoyer de l'air refroidi vers les armoires informatiques ou d'aspirer de l'air réchauffé par les armoires informatiques par le biais de ladite ouverture.

Suivant des modes de réalisation préférés, le module comprend une ou plusieurs des caractéristiques suivantes :
- le module est prévu pour que le conduit de circulation d'air soit formé par aboutement de modules identiques disposés en enfilade selon leur profondeur sur une seule file de modules ;
- le module est prévu pour que le conduit de circulation d'air soit formé par aboutement de modules identiques disposés en enfilade selon leur profondeur sur deux files de modules côte à côte assemblés entre eux ;
- le module est prévu pour que le conduit de circulation d'air soit formé par aboutement de modules identiques disposés en enfilade en coopération avec le plafond d'une salle ;
- le côté du module s'étendant par delà la rangée d'armoire comprend une partie destinée à former un plafond de confinement d'un couloir formé entre la rangée d'armoire et une autre rangée d'armoires parallèle ou une cloison formant éventuellement un mur d'une salle, éventuellement en coopération avec les modules assemblés en enfilade sur le dessus des armoires informatiques de l'autre rangée ;
- l'ouverture est formée dans une zone participant au plafond formé entre les deux rangées d'armoires ;
- le module comprend en outre une structure et des dimensions permettant d'assembler les modules en enfilade sur le dessus des armoires informatiques d'une rangée avec un premier et un second côté des modules s'étendant de part et d'autre au delà de cette rangée d'armoires informatiques en direction respectivement d'une première et d'une deuxième rangées d'armoires informatiques adjacentes à cette rangée pour former un premier et un deuxième plafonds entre cette rangée et respectivement la première et la deuxième rangées en coopération avec les côtés de modules assemblés en enfilade sur le dessus des armoires informatiques de la première rangée et respectivement de la deuxième et de la troisième rangées ;
- le module comprend des parois complémentaires de chaque côté du module formant de chaque côté deux parties de section de conduit en forme de U couché avec l'ouverture vers l'extérieure du côté du module ;
- le module comprend au moins une partie de chemin de câble d'un côté du module destinée à former avec d'autres parties de chemin de câble des modules assemblés en enfilade un chemin de câble ;
- le module comprend une paroi inférieure participant au plafond formé entre les deux rangées d'armoires, la paroi inférieure formant une trappe d'accès permettant à un utilisateur d'avoir accès à l'intérieure du module lorsque les modules sont assemblés en enfilade sur le dessus des armoires informatiques formant la rangée ;
- le module comprend un groupe de climatisation prévu pour aspirer de l'air dans une section de conduit et refouler de l'air dans une autre section de conduit ;
- la profondeur du module entre l'avant et l'arrière du module est comprise entre 600mm et 800mm ou correspond à la largeur de plusieurs armoires et dans lequel la largeur du module entre les deux extrémités des côtés du module est comprise entre 1000 et 2400mm, de préférence entre 2000 et 2400mm ;
- le module comprend une lampe fixée sur une zone participant au plafond formé entre les deux rangées d'armoires pour éclairer le couloir confmé par le plafond.

La présente invention propose aussi une installation comprenant au moins un ensemble d'armoires et de modules précédemment décrits, l'ensemble comprenant :
- une rangée d'armoires informatiques contiguës formant un pan d'un couloir,
- une rangée de modules assemblés en enfilade sur la rangée d'armoiries informatiques contiguës,
dans laquelle la rangée de modules comporte un côté s'étendant par-delà les façades des armoires informatiques dans laquelle la rangée de modules forme au moins un conduit de circulation d'air longeant le couloir éventuellement en coopération avec une deuxième rangée de modules assemblés en enfilade sur le dessus d'une deuxième rangée d'armoires informatiques formant l'autre pan du couloir ou avec l'autre pan du couloir et éventuellement en coopération avec un plafond d'une salle, et
dans laquelle l'ouverture ou la découpe de chaque module forme une pluralité d'ouverture dans la zone participant au plafond du couloir.

Suivant des modes de réalisation préférés, l'installation comprend une ou plusieurs des caractéristiques suivantes :
- le côté des modules s'étendant par-delà les façades des armoires informatiques, forme au moins une partie d'un plafond du couloir;
- la rangée de modules forme au dessus de la rangée d'armoires un premier conduit pour circuler de l'air froid et un second conduit pour circuler de l'air chaud ;
- le nombre d'ensembles est au moins trois et dans laquelle :
   - les armoires informatiques du deuxième ensemble forment l'autre pan du couloir,
   - les rangées d'armoires informatiques du premier et troisième ensembles forment un autre couloir,
   - les côtés de la rangée de modules du premier ensemble coopèrent respectivement avec un côté des rangées de modules du deuxième et du troisième ensembles formant un plafonds respectif pour les couloirs,
   - les rangées de modules du premier et deuxième ensembles forment le premier conduit de circulation d'air, et
   - les rangées de modules du premier et troisième ensembles forment le deuxième conduit de circulation d'air longeant le deuxième couloir ;
- l'installation comprend un groupe de climatisation, dans laquelle le premier conduit est relié à l'entrée du groupe de climatisation pour aspirer l'air du premier couloir par le biais des ouvertures formées dans le premier plafond et dans laquelle le deuxième conduit est relié à la sortie du groupe de climatisation pour souffler de l'air dans le deuxième couloir par le biais des ouvertures formées dans le deuxième plafond ;
- l'installation comprend un groupe de climatisation et dans laquelle chaque extrémité de chaque conduit est fermée ou est reliée à une sortie ou une entrée du groupe de climatisation.

D'autres caractéristiques et avantages de l'invention apparaîtront à la lecture de la description qui suit des exemples préférés de l'invention, donnés à titre d'exemple et en référence au dessin annexé.
La figure 1 représente schématiquement une coupe de deux modules vue de face selon un premier exemple de l'invention, montés chacun sur une armoire informatique.
La figure 2 représente une vue de face d'une armoire informatique sur laquelle est monté un module selon le premier exemple.
La figure 3 représente un schéma d'une installation vu de dessus suivant une coupe A-A de la figure 1, d'une salle informatique comprenant des modules, selon le premier exemple, montés sur des armoires informatiques.
La figure 4 représente une vue de dessous du module selon le premier exemple.
La figure 5 représente schématiquement une autre installation d'un module vue de face sur une armoire d'une rangée dans une salle.
Les figures 6, 7 et 8 représentent schématiquement un module suivant un deuxième exemple sur une armoire.
La figure 9 représente schématiquement un module, suivant un troisième exemple, sur une armoire vue de côté.

Un module selon l'invention est destiné à former conjointement avec d'autres modules identiques au moins un conduit de circulation d'air par agencement des modules sur le dessus des armoires informatiques d'une rangée. Les armoires informatiques ont des dimensions extérieures standardisées et sont conçu pour recevoir des machines informatiques tels que des serveurs. Le module présente une structure et des dimensions permettant d'assembler les modules en enfilade sur le dessus des armoires informatiques de la rangée avec un côté des modules s'étendant par-delà cette rangée d'armoires informatiques.

Selon une première façon de réaliser l'invention, le module présente au moins une section de conduit ou une partie de conduit ouvert vers le haut pour former une section de conduit en coopérant avec un plafond d'une salle. La section de conduit éventuellement formé avec le plafond de la salle débouche à l'avant et à l'arrière du module pour former au moins un conduit de circulation d'air par aboutement des sections de conduite de modules assemblés en enfilade. L'air circulant dans le conduit peut être de l'air frais (air ayant une température assez basse pour refroidir les machines dans les armoires) envoyé vers les machines ou de l'air réchauffé par les machines. Le module présente en outre une ouverture ménagée dans ladite section de conduit ou une découpe à un bord de la section du conduit pour former une ouverture en coopération avec un module contiguë assemblé en enfilade. Ladite ouverture débouche sur le dessous du ou des modules.

Selon une deuxième façon de réaliser l'invention, le module peut présenter des parois complémentaires de chaque côté du module adaptées à former, par assemblage côte à côte de deux modules et éventuellement en coopérant avec un plafond d'une salle, une section de conduit. La section de conduit débouche à l'avant et à l'arrière des deux modules pour que l'assemblage de modules en enfilade sur les deux rangées côte à côte et éventuellement en coopérant avec le plafond forme un conduit de circulation d'air. Par côté du module, on entend la partie du module située à l'avant ou à l'arrière de l'armoire sur lequel le module est agencé. L'air circulant dans le conduit peut être de l'air frais (air ayant une température assez basse pour refroidir les machines dans les armoires) envoyé vers les machines ou de l'air réchauffé par les machines. Le module présente en outre une ouverture ménagée dans les parois complémentaires dans le conduit de circulation d'air ou une découpe au bord des parois complémentaires pour former, en coopération avec au moins un autre module auquel il est assemblé, une ouverture dans le conduit de circulation d'air. Ladite ouverture débouche sur le dessous du ou des modules.

L'avant et l'arrière du module ne sont pas suivant la direction de l'avant et l'arrière de l'armoire mais suivant la direction des côtés de l'armoire. De ce fait, la direction de l'avant et l'arrière du module sont suivant la direction longitudinale du conduit formé par les sections de conduit.

L'ouverture permet à l'air de passer du conduit vers le couloir ou du couloir vers le conduit. De plus, les ouvertures permettent de répartir la circulation de l'air entre le couloir et le conduit. L'ouverture peut comprendre une grille de ventilation comprenant des ailettes orientées vers l'armoire informatique afin de diriger l'air expirer du conduit vers l'armoire ou d'aspirer l'air réchauffé par les machines.

Le ou les conduits peuvent être raccordés à un ou plusieurs groupes de climatisation permettant d'envoyer l'air refroidi par le groupe vers les armoires par le biais des ouvertures ou d'aspirer l'air réchauffé par les machines reçues dans les armoires pour le refroidir.

Le conduit et le couloir entre les deux rangées d'armoires permettent d'optimiser la consommation d'énergie pour refroidir des équipements informatiques dans les armoires en envoyant directement l'air frais vers les armoires.

Selon un exemple de l'invention, le module comprend de chaque côté s'étendant au-delà la rangée d'armoire un paroi inférieure en direction d'une cloison ou d'une autre rangée d'armoires informatiques pour former un plafond entre la cloison et la rangée ou entre les deux rangées éventuellement en coopération avec les modules assemblés en enfilade sur le dessus des armoires informatiques de l'autre rangée.

Le plafond permet de confiner un couloir entre les deux rangées d'armoires informatiques ou entre la rangée et une cloison. La cloison peut être un mur de la salle ou une ou des plaques agencées contre le côté des modules descendant jusqu'au plancher.La rangée d'armoire sur lequel est agencé le module est parallèles à l'autre rangée d'armoire ou à la cloison.

Selon un autre exemple, en particulier dans le cas de petites salles machines ne comportant qu'une seule rangée d'armoires, un couloir est formé entre l'avant des armoires et le mur de la salle qui lui fait face et qui lui est parallèle. En particulier, le couloir peut être le couloir d'air frais. Un autre couloir d'air, en particulier d'air chaud (réchauffé par les machines) est formé entre l'arrière des armoires et le mur de la salle qui lui fait face et qui lui est parallèle. Les modules agencés en enfilade ont une hauteur égale à la hauteur du plafond de la salle moins la hauteur de l'armoire. Ainsi les modules et les armoires séparent les deux couloirs d'air chaud et d'air froid.

Outre ses avantages techniques et fonctionnels, l'invention a pour avantage d'être très simple à fabriquer et à monter et donc peu coûteux. En effet, le module peut être fabriqué avec des plaques et des profilés, par exemple sous forme de structure mécano-vissée voire mécano-soudée.

L'agencement des modules sur le dessus des armoires permet de s'adapter aisément à une extension du nombre d'armoires à installer dans la salle informatique en plaçant une nouvelle armoire informatique contiguë à la dernière armoire informatique d'une rangée ou en plaçant l'armoire à côté d'une rangée pour former une nouvelle rangée d'armoires et en agençant un module sur le dessus de la nouvelle armoire.

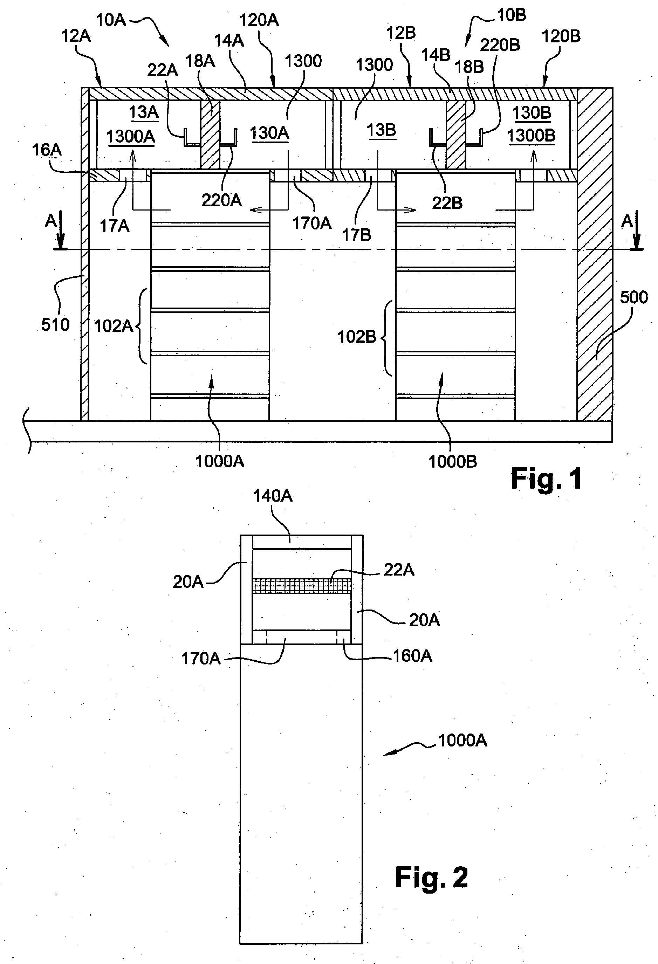

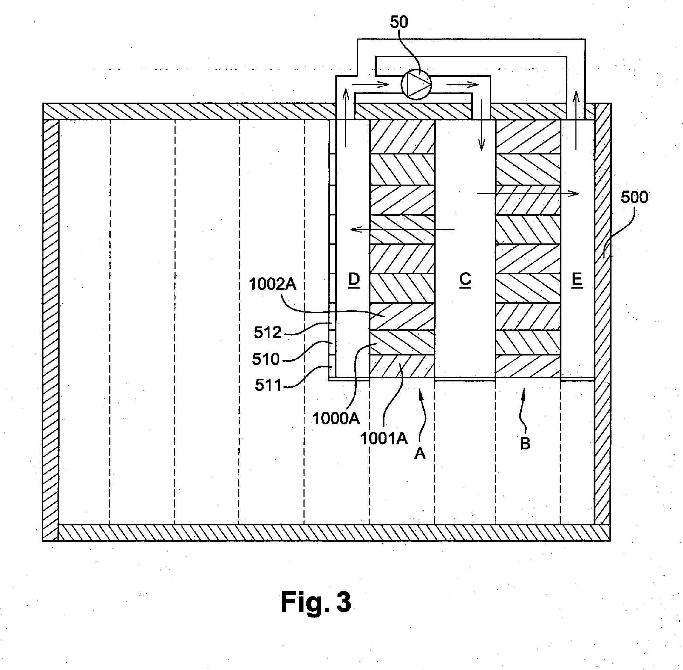

La figure 1 représente schématiquement une coupe de deux modules 10A, 10B vue de face, selon un premier exemple de l'invention. Par vue de face du module, on entend la vue du module lorsqu'on regarde vue de côté l'armoire sur lequel le module est monté. En particulier, la figure 1 représente une installation d'un premier et d'un deuxième modules 10A, 10B agencés respectivement sur un premier et une deuxième racks informatiques 1000A, 1000B, appelés dans la suite armoires. Les armoires 1000A et 1000B sont contiguës à d'autres armoires 1001A, 1002A, 1001B, 1002B formant respectivement une première et une deuxième rangées A, B d'armoires informatiques. Les rangées A, B, sont parallèles et séparées entre elles d'une distance prédéterminée. Dans chaque rangée A, B, les façades (face avant) des armoires par lesquelles les équipements informatiques sont installés, sont contiguës et sont en vis-à-vis d'une façade de l'autre rangée. Les armoires 1000A, 1001A, 1002A, etc... de chaque rangée ne sont pas représentées sur la figure 1, mais sont visibles sur la figure 3. La figure 3 représente un schéma de l'installation vue de dessus suivant une coupe A-A suivant la figure 1, d'une salle informatique comprenant des modules selon le premier exemple, montés sur des armoires informatiques. L'installation comprend une première et une deuxième rangées d'armoires informatiques A et B. Un couloir C est formé entre les deux rangées A et B.

Les armoires ont des dimensions extérieures standardisées. Les armoires ont une largeur entre 600 et 800 mm et une profondeur entre 1000 et 1200. Par largeur on entend la largeur de la façade de l'armoire par laquelle des équipements informatiques peuvent être introduits.

Sur la figure 1, les armoires 1000A, 1000B sont représentées vue de côté d'une manière simplifiée. Dans chaque rangée, les armoires 1000A, 1000B ont la même largeur, mais il est possible au sein d'une même rangée de disposer d'armoires de largeurs différentes. Chaque armoire 1000A, 1000B comprend une pluralité d'étagères ou tiroirs 102A, 102B ou peut recevoir des équipements informatiques rackables directement sur des feuillures normalisées permettant de les fixer. Chaque armoire 1000A, 1000B comprend un toit 104A, 104B.

Dans cet exemple, le premier et le deuxième modules 10A, 10B sont posés respectivement sur le toit 104A, 104B de la première et de la deuxième armoire 1000A, 1000B. Les modules agencés en enfilade sur le dessus des armoires forment une rangée de module. Les deux modules 10A, 10B sont identiques. Dans la suite, seul le premier module 10A est décrit. La description faite pour le premier module 10A est valable pour le module 10B. Les éléments du deuxième module 10B identiques aux éléments du premier module 10A sont référencés par le même nombre mais en remplaçant la lettre A par la lettre B.

Le module 10A comprend deux côtés 12A et 120A. Les deux côtes 12A et 120A forment deux parties de section de conduit 13A, 130A débouchant à l'avant et à l'arrière du module 10A. L'avant et l'arrière des modules sont suivant la direction de la longueur de la rangée alors que l'avant et l'arrière des armoires sont suivant la direction de la largeur de la rangée. Sur la figure 1, on peut voir que chaque côté du module s'étend par-delà la face avant et la face arrière de l'armoire informatique. Le module comprend donc une largeur plus grande que la profondeur de l'armoire sur laquelle il est monté. La largeur du module est mesurée entre les deux extrémités des deux côtés du module et la profondeur de l'armoire entre l'avant et l'arrière de l'armoire. La somme des largeurs des parties de chaque côté s'étendant par-delà les deux faces d'armoire informatique est égale à la distance prédéterminée entre les deux rangées. Le module peut avoir une largeur comprise entre 2000 et 2400 mm. Sur la figure 1, le côté 120A du premier module 10A est assemblé avec un côté 12B du deuxième module 10B.

Chaque côté du module 10A comprend des parois complémentaires : une paroi supérieure 14A, une paroi inférieure 16A, 160A. Le module comprend en outre une paroi verticale 18A séparant les deux côtés. Dans cet exemple, les côtés sont identiques. La paroi inférieure 16A et la paroi supérieure 14A sont perpendiculaires à la paroi verticale 18A. Les parois de chaque côté forment une partie de section de conduit en forme de U couché avec l'ouverture vers l'extérieure du côté du module.

Chaque côté 12A, 120A a donc la forme d'un parallélépipède ouvert à l'avant, à l'arrière et sur le côté du module. Le module a donc aussi la forme d'un parallélépipède. Les parois de chaque côté 12A et 12B sont complémentaires pour former une section de conduit en assemblant deux modules côte à côte.

L'assemblage des deux modules 10A, 10B côte à côte, relie les deux parois inférieure 160A, et supérieure 140A d'un côté du premier module 10A aux deux parois inférieure 16B et supérieure 14B d'un côté du deuxième module 10B. La partie de section de conduit 130A d'un côté du premier module 10A aboutée avec l'autre partie de section de conduit 13B d'un autre côté du module 10B forme une section d'un conduit 1300 au dessus du couloir C.

Les modules de la première rangée et de la deuxième rangée alignent des sections de conduit formant le conduit 1300. L'assemblage des parois inférieures 160A, 16B des modules de la première rangée et de la deuxième rangée forme un plafond du couloir C. Chaque paroi inférieure 16A, 160A d'un côté du module forme ainsi une zone participant à un plafond d'un couloir formé par la partie avant ou arrière de l'armoire correspondante.

La partie de section de conduit 120B de l'autre côté du module 10B a son ouverture fermée par un mur 500 de la salle des machines. Les parties de sections 130B des modules 10B alignés forment en coopérant avec le mur 500 un conduit 1300B. Le mur 500 forme avec l'arrière des armoires de la rangée B un couloir E.

De l'autre côté 12A du module 10A, le module 10A comprend une paroi 510 fermant l'ouverture de la partie de section 13A. Les parties de sections 13A des modules 10A alignés forment en coopérant avec la paroi 510 un conduit 1300A. La paroi 510 descend jusqu'au sol 600 et est alignée avec d'autres parois 511, 512... faisant face à d'autres armoires 1001A, 1002A de la rangée A. Un couloir D est formé entre les faces arrières des armoires de la rangée A et les parois 510, 511, 512....

Selon un autre exemple non représenté, un côté du module comprend une paroi verticale d'un côté du module pour que l'assemblage des deux modules 10A, 10B côte à côte forme deux sections de conduits au-dessus de la rangée C. Ainsi deux conduits sont formés au-dessus du couloir C. Ces deux sections de conduits peuvent permettent de refroidir différemment les armoires des deux rangées A et B du fait des caractéristiques thermiques différentes des machines qu'ils hébergent. Par exemple, dans le conduit formé du côté de la rangée A, le débit d'air peut être plus important que dans le conduit du côté de la rangée B. Selon un autre exemple, l'air envoyé dans le conduit du côté de la rangée A est plus froid que l'air envoyé dans le conduit du côté de la rangée B.

Les modules 10A, 10B comprennent de chaque côté une ouverture 17A, 170A, 17B, 170B dans les parois inférieures 16A, 160A, 16B, 160B. Cette ouverture est située dans la zone participant au plafond formé entre les deux rangées d'armoires.

Chaque module comprend en outre deux parties de chemin de câbles 22A, 220A, 22B, 220B. Les deux parties de chemin de câbles sont fixées sur une face de la paroi verticale. Chaque partie de chemin de câbles est assemblée en enfilade avec d' autres parties de chemin de câbles des modules assemblés en enfilade. Ces chemins de câbles permettent d'amener les câbles de courant fort ou faible alimentant les équipements informatiques dans l'armoire.

Dans cet exemple, les parois inférieures 16A, 160A de chaque module sont séparées l'une de l'autre selon une distance équivalente à la profondeur de l'armoire sur laquelle le module est agencé. Les parois inférieures 16A, 160A forment donc uniquement la zone participant au plafond. Dans cet exemple, les toits 104A, 104B de chaque armoire 1000A, 1000B sont encastrés dans le module 10A, 10B correspondant entre les deux parois inférieures 16A, 160A du module correspondant et sont en contact avec le dessous de la paroi verticale 18A du module correspondant.

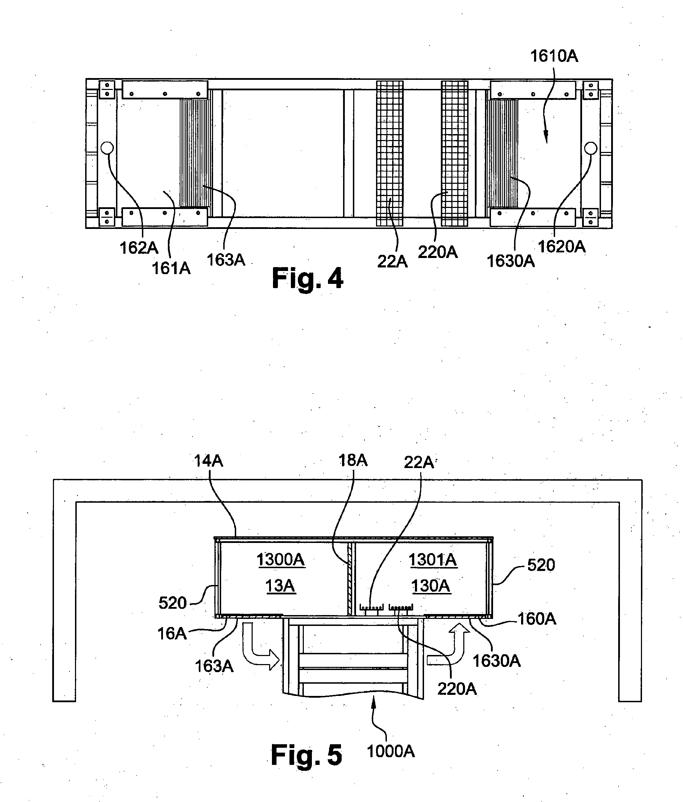

La figure 4 représente une vue de dessous du module. Chaque paroi inférieure de chaque côté du module 16A et 160A contient une grille de ventilation 163A, 1630A permettant de diffuser l'air froid ou aspirer l'air chaud.

La paroi inférieure de chaque côté du module est formée par une trappe 161A, 1610A et une plaque comprenant une lampe 162A, 1620A. La trappe permet à un utilisateur d'avoir accès aux câbles posés sur la partie de chemin de câble à l'intérieure du module.

La lampe permet d'éclairer le couloir et les armoires. La lampe peut être aussi fixée sur la trappe tel que dans le deuxième exemple décrit plus bas.

L'accès à ces chemins de câbles s'effectue en déplaçant les parois inférieures 16A ou 160A par évacuation provisoire de la paroi.

La figure 2 représente une vue de face d'une seule armoire informatique 1000A sur laquelle est monté un seul module 10A. Sur la figure 2, le module 10A est vu de côté. Dans cet exemple, la profondeur du module 10A est égale à la largeur de la face avant par laquelle des équipements informatiques sont introduits dans l'armoire 1000A. Le module peut avoir une profondeur comprise entre 600 mm et 800 mm ou encore peut être égale à plusieurs largeur d'armoires.

Chaque côté 12A, 120A du module comprend en outre deux profilés 20A reliant les coins avant et arrière du côté extérieure de la paroi inférieure 16A, 160A et de la paroi supérieure 14A, 140A. Les profilés permettent de renforcer la structure du module. Une des ouvertures, en particulier l'ouverture 170A traversant la paroi inférieure 160A est représentée en pointillé.

Sur la figure 3, le conduit 1300 est relié à la sortie d'un groupe de climatisation 50 par le biais d'une canalisation. Les conduits 1300A et 1300B sont raccordés à l'entrée du groupe de climatisation. Le groupe de climatisation refroidit l'air provenant des conduits 1300A et 1300B et le refoule dans le conduit 1300. Le conduit 1300 est donc un conduit d'air frais qui envoie par le biais de ses ouvertures l'air refroidi vers les armoires. Les armoires comprenant les machines ventilant de la face avant à la face arrière ont des portes perforées, voire pas de porte afin de laisser circuler l'air du couloir vers les machines. Les machines dans les armoires aspirent l'air refroidi, la réchauffe et l'évacuent vers l'arrière des armoires (perforée ou sans paroi). L'air chaud (réchauffé) est alors évacué des armoires vers le couloir D ou E correspondant. Le groupe de climatisation aspire l'air réchauffé respectivement dans les couloir D et E par le biais respectivement des conduits 1300A et 1300B et de leurs ouvertures. Les ouvertures 170A, 17B, formées dans le plafond du couloir C permettent de répartir le refoulement d'air refroidi dans les différentes armoires du couloir C. L'air frais (refroidi) n'est donc pas mélangé avec l'air de la salle et est donc plus efficace pour refroidir les machines. L'air réchauffé par les machines est aspiré par le groupe de climatisation dont l'efficacité sera d'autant plus importante que l'air est chaud. Sur la figure 3, des flèches représentent le trajet de l'air.

L'agencement des modules sur le dessus des armoires permet de s'adapter aisément à une extension du nombre d'armoires à installer dans la salle informatique en plaçant une nouvelle armoire informatique contiguë à la dernière armoire informatique d'une rangée ou en plaçant l'armoire à côté d'une rangée pour former une nouvelle rangée d'armoires et en agençant un module sur le dessus de la nouvelle armoire. Dans le cas d'une nouvelle rangée d'armoires, les armoires informatiques de la nouvelle rangée forment l'autre pan d'un autre couloir. Par pan de couloir, on entend une rangée d'armoire ou une cloison (par exemple un mur de la salle). Chaque armoire d'une rangée entre deux autres rangées d'armoires a sa face avant en face d'une face avant d'une rangée contiguë et sa face arrière face à une face arrière d'une armoire de l'autre rangée contiguë. Les parois complémentaires des modules sur les armoires de la rangée entre deux autres rangées d'armoires coopèrent avec les autres modules des rangées contiguës pour former deux conduits d'aérations chacun au dessus d'un couloir formé entre la rangée et une des deux autres rangées d'armoires.

Dans certains cas, on préfèrera traiter (refroidir) l'air de chaque couloir par un groupe de climatisation indépendant monté en bout de couloir, voire avec un groupe monté à chaque bout de couloir pour des raisons de perte de charge et/ou de redondance. Dans cette installation, chaque groupe de climatisation refroidira soit une rangée d'armoires, soit deux rangées d'armoires en vis-à-vis. En cas de panne d'un des deux groupes de climatisation, la paroi séparant les couloirs de même nature (respectivement froids ou chauds) pourra être ouverte pour permettre à l'air frais généré et à l'air chaud refoulé d'alimenter les armoires de la partie dont le climatiseur est arrêté.

La figure 5 représente schématiquement une autre installation d'un module vue de face sur une armoire. Dans cette installation, la salle informatique comprend une seule rangée d'armoires.

Les murs de la salle sont trop éloignés de la rangée d'armoire pour que les modules 10A agencés en enfilade forment un plafond. Le module comprend de chaque côté du module une paroi 520 fermant l'ouverture de la partie de section 13A, 130A. Les parois 520 et la partie de section de chaque côté du module forment avec les autres parties de section et les autres parois 520 montées sur les modules agencés en enfilade, deux conduits. Un conduit 1300A, en l'occurrence le conduit de gauche sur la figure 5, est le conduit d'air frais et l'autre conduit 1301A (de droite) est le conduit d'air chaud. Les grilles de ventilation 163A dirigent l'air frais circulant dans le conduit d'air frais vers les façades des armoires de la rangée. L'air frais est aspiré par les machines et est refoulé de l'autre côté de l'armoire. L'air réchauffé par les machines est aspiré par les grilles de ventilation 1630A du conduit chaud. Dans cet exemple, il n'y a pas de confinement d'un couloir, mais l'air frais est tout de même envoyé vers la façade de l'armoire et l'air chaud à la sortie de la face arrière est aspiré vers le conduit d'air chaud.

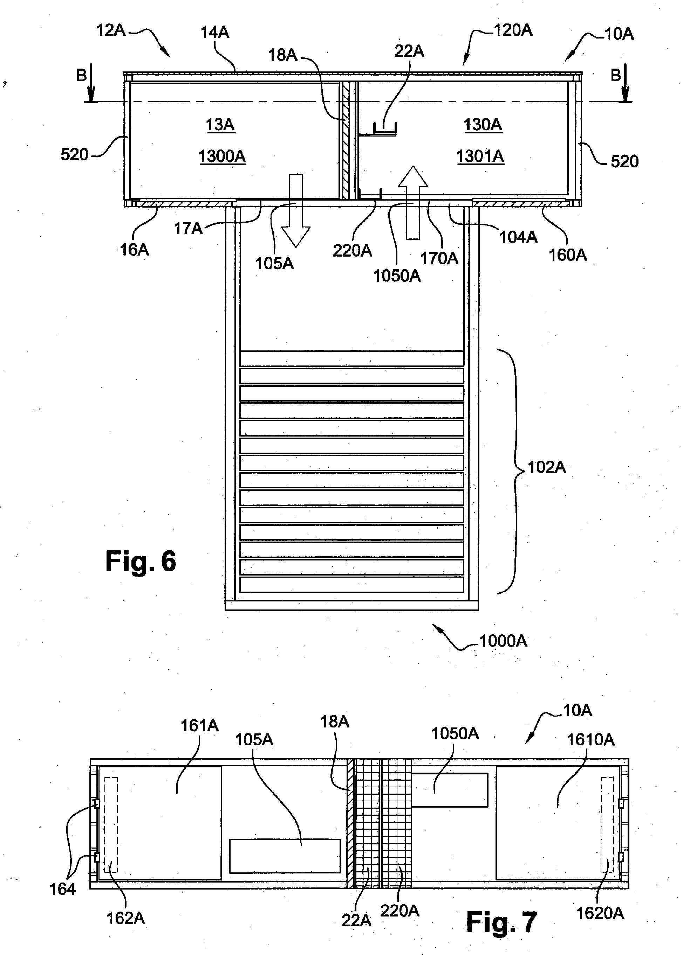

Les figures 6, 7 et 8 représentent schématiquement un module 10A suivant un deuxième exemple sur une armoire 1000A.

Ce deuxième exemple est basé sur celui du premier exemple décrit en relation avec les figures 1, 2,3 et 4. De ce fait, la description faite pour le premier exemple est applicable aussi à ce deuxième exemple, sauf pour les différences qui sont exposées ci-après. Les éléments identiques ou semblables au premier exemple portent le même numéro de référence.

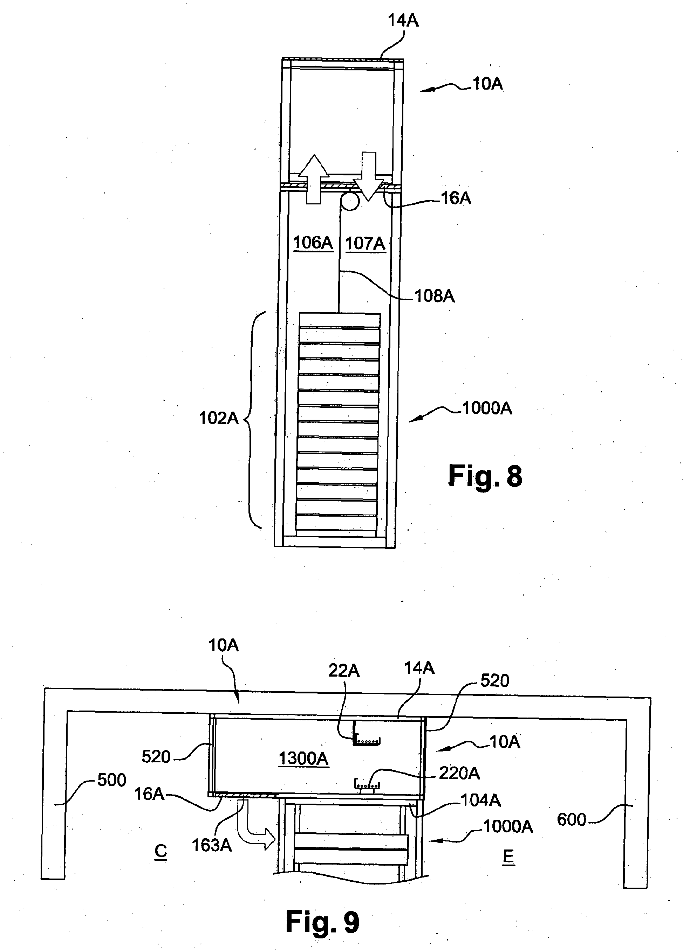

La figure 6, représente schématiquement une vue de face du module 10A sur une armoire 1000A vue de côté. L'armoire 1000A reçoit des machines disposant d'une ventilation latérale et non frontale. L'armoire 10A comprend deux ouvertures 105A; 1050A situées sur son toit 104A. Une des ouvertures 105A et dans la partie avant 106A de l'armoire 1000A et l'autre ouverture 1050A dans la partie arrière 107A de l'armoire 1000A. Les partie avant 105A et arrière 1050A sont référencées sur la figure 8 qui représente le module 10A vue de côté sur l'armoire 1000A vue de face. Une des deux ouvertures 105A débouche sur le côté du toit 104A par lequel les machines aspirent l'air frais et débouche sur le conduit 1300A froid formé par les modules assemblés en enfilade; l'autre ouverture 1050A débouche sur le côté par lequel les machines refoulent l'air chaud et débouche sur le conduit 1301A chaud formé par les modules assemblés en enfilade.

L'armoire 1000A comprend en outre une paroi verticale 108A fixée sur le toit 104A de l'armoire 1000A entre la partie avant 106A et la partie arrière 107A et descend jusqu'à la machine installée la plus haute dans l'armoire 100A. Cette paroi 108A est visible sur la figure 8. Cette paroi 108A permet de séparer la partie avant 106A de l'armoire, en l'occurrence froide et la zone arrière 107A, en l'occurrence chaud au dessus des machines dans l'armoire 1000A. Cela permet d'assurer l'herméticité entre la partie froide et la partie chaude de chaque armoire. En l'occurrence, la paroi 108A est un dispositif de store spécialement adapté pour séparer la zone avant et la zone arrière. Ce store permet de régler la capacité du nombre d'équipements installés tout en séparant l'air froid de l'air chaud dans l'armoire. Contrairement aux armoires destinées à recevoir des équipements ventilant de la face avant à la face arrière, ces armoires ont des portes pleines sans ouverture. Les portes pleines peuvent comprendre un oculus transparent.

Des flèches représentent sur les figures 6 et 8 le sens du flux d'air entre les conduits et les parties dans l'armoire 1000A.

La figure 7 représente une vue de dessus suivant la coupe B-B de la figure 6. A la différence du premier exemple décrit, le module 10A ne comprend pas d'ouverture dans les parois inférieures 16A, 160A, formant le plafond.

Dans cet exemple, chaque lampe 162A, 1620A est fixée sur la trappe 161A, 1610A correspondante. Comme dans le premier exemple, la lampe 162A, 1620A permet d'éclairer le couloir et les armoires et permet en outre d'éclairer à l'intérieure du conduit lorsque la trappe est ouverte. Dans cet exemple, l'accès à ces chemins de câbles s'effectue par une rotation de la trappe vers le haut par le biais de charnières 164, visible sur la figure 7, situées respectivement pour chaque trappe à chaque extrémité du côté du module 10A.

Le module 10A peut comprendre en outre, pour chaque trappe, des dispositifs d'assistance et/ou de sécurité (non représentés) qui permettent respectivement d'assister l'ouverture de la trappe et de sécuriser la tenue de la trappe en position ouverte.

Dans cet exemple, les parties de chemins de câbles 22A, 220A sont situées dans le même conduit 1301A à différente hauteur. Cela permet d'avoir accès facilement aux câbles dans le même conduit.

La figure 9 représente schématiquement un module 10A, suivant un troisième exemple, sur une armoire vue de côté.

Ce troisième exemple est basé sur celui du premier exemple de module décrit en relation avec les figures 1, 2, 3, 4 et 5. En particulier, l'installation de ce module 10A sur l'armoire 1000A est basée sur l'installation de la figure 5. De ce fait, la description faite pour le premier exemple est applicable aussi à ce troisième exemple, sauf pour les différences qui sont exposées ci-après. Les éléments identiques ou semblables au premier exemple portent le même numéro de référence.

Dans cet exemple, le module 10A comprend une seule section de conduit. Les modules alignés forment donc un seul conduit 1300A. Le module 10A comprend qu'une paroi inférieure 16A qui s'étend au-delà de la face avant de l'armoire 1000A.

Dans cette installation, le module 10A est monté sur le toit 104A de l'armoire 1000A. Le module 10A a une hauteur correspondant à la hauteur de la salle moins la hauteur de l'armoire 1000A. Ainsi, les modules assemblés en enfilade forment avec les armoires de la rangée deux couloirs : un premier couloir C entre les faces avant des armoires et un mur 500 de la pièce qui leur fait face et un second couloir E entre les faces arrière des armoires et un mur 600 de la pièce qui leur fait face. Le conduit 1300A est un conduit d'air froid qui envoie l'air vers la face avant des armoires 1000A par le biais des grilles de ventilation 163A situées dans les parois inférieures 16A des modules 10A assemblés en enfilade. Ainsi l'air circulant dans le premier couloir C est frais et l'air circulant dans le second couloir E est chaud. Dans cette installation, le groupe de climatisation 50 a son entrée reliée au second couloir E pour aspirer l'air chaud et refoule l'air refroidit dans le conduit d'aération 1300A.

Bien entendu, la présente invention n'est pas limitée aux exemples décrits et représentés.

En particulier, selon les différents exemples décrits, chaque côté du module peut être différent. Selon un exemple, le module comporte de chaque côté deux sections de conduit de taille différente. Selon un autre exemple, le module comporte sur son premier côté des parois complémentaire à son deuxième côté, tel que en associant le deuxième côté d'un autre module avec le premier côté du module, les parois forment une section de conduit. Par exemple, les parois complémentaires d'un côté peuvent former une partie de section de conduit d'un côté en forme de L et de l'autre côté une partie de section de conduit en forme de L à l'envers. Les deux parties de section de conduits formant une section de conduit en forme de parallélépipède lorsqu'elles sont aboutées.

Selon un autre exemple, le module comprend une seule section de conduit ou une partie de section de conduit formant une section de conduit avec le plafond de la salle. Le module est destiné à être agencé au dessus de deux rangées d'armoires pour confiner un couloir entre les deux rangées d'armoires. Le module comprend une paroi inférieure formant le plafond avec d'autres parois inférieures de modules assemblés en enfilade. La section de conduit forme un conduit d'aération destiné à l'air froid en coopérant avec d'autres modules assemblés en enfilade.

Selon un autre exemple, la section de conduit d'aération est en forme de triangle et est formé par la paroi supérieure et une autre paroi inclinée par rapport à la paroi supérieure.

Selon un autre exemple, chaque module est fixé au plafond de la salle. Par exemple, chaque module peut comporter une paroi verticale descendant en dessous de la paroi formant le plafond pour séparer les couloirs. Cela permet de rehausser la hauteur du plafond lorsque l'armoire n'est pas assez haute.

Selon un autre exemple, les modules sont fixés au plafond de la salle par des tiges filetées. Les modules sont agencés sur le dessus des armoires. Les tiges filetées permettent de régler la hauteur du module et peuvent permettre notamment de déplacer l'armoire facilement en rehaussant le module agencé sur l'armoire.

Selon un autre exemple, le module est agencé sur le dessus de deux armoires, forme un plafond entre les deux armoires et comprend une section de conduit au dessus du couloir formé entre les deux rangées d'armoires.

Selon un autre exemple, le module ne comprend pas dans la paroi inférieure l'ouverture mais une découpe à un bord de la section du conduit pour former l'ouverture en coopération avec un module contiguë assemblé en enfilade. Selon un autre exemple, la découpe au bord est formée dans la paroi inférieure pour former en coopération avec au moins une autre paroi inférieure d'un autre module assemblé en enfilade ou côte à côte, une des ouvertures permettant la circulation d'air entre le conduit et le couloir.

Selon un autre exemple, le module peut avoir une profondeur égale à 2 ou 3 largeurs d'armoires ce qui permettra de réduire les coûts de fabrication. Dans cet exemple, pour assister l'ouverture des trappes pivotantes, un dispositif de vérins à gaz peut être installé.

## Revendications

1. Module (10A) destiné à former conjointement avec d'autres modules (10B; 10C) identiques au moins un conduit de circulation d'air (1300) par agencement des modules (10A) sur le dessus des armoires informatiques (1000A) d'une ou deux rangées (A), l'au moins un conduit de circulation d'air formé étant prévu pour s'étendre selon la direction de la longueur de la ou des rangées d'armoires informatiques, les armoires informatiques (1000A) ayant des dimensions extérieures standardisées, lequel module (10A) présente une profondeur entre l'avant et l'arrière du module et une largeur entre deux côtés (12A, 120A) du module permettant d'assembler les modules (10A) en enfilade selon leur profondeur sur le dessus des armoires informatiques (1000A) d'une rangée avec au moins un des deux côtés (12A, 120A) des modules s'étendant par-delà la largeur de cette rangée d'armoires informatiques, dans lequel le module comprend une ouverture (17A ; 170A) débouchant sur le dessous du module, le conduit de circulation d'air (1300) formé par aboutement de modules identiques (10A) assemblés en enfilade selon la longueur d'une rangée ou de deux rangées côte à côte d'armoires informatiques permettant d'envoyer de l'air refroidi vers les armoires informatiques ou d'aspirer de l'air réchauffé par les armoires informatiques par le biais de ladite ouverture.

2. Module selon la revendication 1, dans lequel le module est prévu pour que le conduit de circulation d'air (1300) soit formé par aboutement de modules identiques (10A) disposés en enfilade selon leur profondeur sur une seule file de modules.

3. Module selon la revendication 1, dans lequel le module est prévu pour que le conduit de circulation d'air (1300) soit formé par aboutement de modules identiques (10A) disposés en enfilade selon leur profondeur sur deux files de modules côte à côte assemblés entre eux.

4. Module selon l'une quelconque des revendications 1 à 3, dans lequel le module est prévu pour que le conduit de circulation d'air (1300) soit formé par aboutement de modules identiques (10A) disposés en enfilade en coopération avec le plafond d'une salle.

5. Module selon l'une quelconque des revendications 1 à 4, dans lequel le côté du module s'étendant par delà la rangée d'armoire comprend une partie destinée à former un plafond de confinement d'un couloir (C) formé entre la rangée d'armoire et une autre rangée d'armoires parallèle ou une cloison formant éventuellement un mur d'une salle, éventuellement en coopération avec les modules assemblés en enfilade sur le dessus des armoires informatiques de l'autre rangée, .l'ouverture étant de préférence formée dans une zone participant au plafond formé entre les deux rangées d'armoires.

6. Module selon l'une quelconque des revendications 1 à 5, comprenant une structure et des dimensions permettant d'assembler les modules (10A) en enfilade sur le dessus des armoires informatiques (1000A) d'une rangée (A) avec un premier et un second côté (12A ; 120A) des modules s'étendant de part et d'autre au delà de cette rangée (A) d'armoires informatiques (100A) en direction respectivement d'une première et d'une deuxième rangées d'armoires informatiques adjacentes à cette rangée pour former un premier et un deuxième plafonds entre cette rangée (A) et respectivement la première et la deuxième rangées en coopération avec les côtés de modules assemblés en enfilade sur le dessus des armoires informatiques de la première rangée et respectivement de la deuxième et de la troisième rangées.

7. Module selon l'une quelconque des revendications précédentes, comprenant au moins une partie de chemin de câble d'un côté du module destinée à former avec d'autres parties de chemin de câble des modules assemblés en enfilade un chemin de câble.

8. Module selon l'une quelconque des revendications précédentes, comprenant une paroi inférieure (16A ; 160A) participant au plafond formé entre les deux rangées (A ; B) d'armoires, la paroi inférieure (16A; 160A) formant une trappe d'accès (161A ; 1610A) permettant à un utilisateur d'avoir accès à l'intérieur du module lorsque les modules sont assemblés en enfilade sur le dessus des armoires informatiques formant la rangée.

9. Module selon l'une quelconque des revendications précédentes, dans lequel la profondeur du module (10A) entre l'avant et l'arrière du module est comprise entre 600 mm et 800 mm ou correspond à la largeur de plusieurs armoires et dans lequel la largeur du module (10A) entre les deux extrémités des côtés du module est comprise entre 1000 et 2400 mm, de préférence entre 2000 et 2400 mm.

10. Module selon l'une quelconque des revendications précédentes, comprenant une lampe (162A ; 1620A) fixée sur une zone participant au plafond formé entre les deux rangées (A ; B) d'armoires pour éclairer le couloir (C) confiné par le plafond.

11. Installation comprenant au moins un ensemble d'armoires et de modules selon l'une quelconque des revendications précédentes, l'ensemble comprenant :
- une rangée (A) d'armoires informatiques contiguës formant un pan d'un couloir (C),
- une rangée de modules assemblés en enfilade sur la rangée (A) d'armoires informatiques contiguës,
dans laquelle la rangée de modules comporte un côté s'étendant par-delà les façades des armoires informatiques (100A) dans laquelle la rangée de modules forme au moins un conduit de circulation d'air (1300) longeant le couloir (C) éventuellement en coopération avec une deuxième rangée de modules assemblés en enfilade sur le dessus d'une deuxième rangée (B) d'armoires informatiques formant l'autre pan du couloir (C) ou avec l'autre pan du couloir (C) et éventuellement en coopération avec un plafond d'une salle, et
dans laquelle l'ouverture (170A) de chaque module (10A) forme une pluralité d'ouvertures dans la zone participant au plafond du couloir.

12. Installation selon la revendication précédente, dans lequel le côté des modules s'étendant par-delà les façades des armoires informatiques (100A) forme au moins une partie d'un plafond du couloir (C).

13. Installation selon la revendication 11 ou 12, dans lequel la rangée de modules forme au dessus de la rangée d'armoires un premier conduit pour circuler de l'air froid et un second conduit pour circuler de l'air chaud.

14. Installation selon la revendication 13, dans laquelle le nombre d'ensembles est au moins trois et dans laquelle :
- les armoires informatiques du deuxième ensemble forment l'autre pan du couloir (C),
- les rangées (A et F) d'armoires informatiques du premier et troisième ensembles forment un autre couloir (D),
- les côtés (12A ; 120A) de la rangée de modules (10A) du premier ensemble coopèrent respectivement avec un côté (12B ; 120F) des rangées de modules du deuxième et du troisième ensembles formant un.plafonds respectif pour les couloirs,
- les rangées de modules du premier et deuxième ensembles forment le premier conduit (1300) de circulation d'air, et
- les rangées de modules du premier et troisième ensembles forment le deuxième conduit de circulation d'air longeant le deuxième couloir (D).

15. Installation selon la revendication 14 comprenant un groupe de climatisation, dans laquelle le premier conduit (1300) est relié à l'entrée du groupe de climatisation (50) pour aspirer l'air du premier couloir (C) par le biais des ouvertures (170A ; 17B) formées dans le premier plafond et dans laquelle le deuxième conduit est relié à la sortie du groupe de climatisation (50) pour souffler de l'air dans le deuxième couloir (D) par le biais des ouvertures formées dans le deuxième plafond.

16. Installation selon l'une quelconque des revendications 11 à 13, comprenant un groupe de climatisation et dans laquelle chaque extrémité de chaque conduit est fermée ou est reliée à une sortie ou une entrée du groupe de climatisation (50).

## Patentansprüche

1. Modul (10A), das dazu bestimmt ist, gemeinsam mit anderen identischen Modulen (10B; 10C) mindestens eine Luftumlaufleitung (1300) durch Anordnung der Module (10A) auf dem Oberteil der Netzwerk- und Serverschränke (1000A) von einer oder zwei Reihen (A) zu bilden, wobei die mindestens eine gebildete Luftumlaufleitung vorgesehen ist, um sich entlang der Richtung der Länge der Reihe oder der Reihen von Netzwerk- und Serverschränken zu erstrecken, wobei die Netzwerk- und Serverschränke (1000A) standardisierte Außenabmessungen aufweisen, wobei das Modul (10A) eine Tiefe zwischen der Vorderseite und der Rückseite des Moduls und eine Breite zwischen zwei Seiten (12A, 120A) des Moduls aufweist, die das Zusammenbauen der Module (10A) in einer Reihe entlang ihrer Tiefe auf dem Oberteil der Netzwerk- und Serverschränke (1000A) einer Reihe ermöglichen, wobei sich mindestens eine der zwei Seiten (12A, 120A) der Module jenseits der Breite dieser Reihe von Netzwerk- und Serverschränken erstreckt, wobei das Modul eine Öffnung (17A; 170A) umfasst, die auf dem Unterteil des Moduls mündet, wobei die Luftumlaufleitung (1300), die durch Aneinanderfügung von identischen Modulen (10A), die in einer Reihe entlang der Länge einer Reihe oder von zwei Reihen von Netzwerk- und Serverschränken Seite an Seite zusammengebaut sind, gebildet ist, das Befördern von gekühlter Luft in Richtung der Netzwerk- und Serverschränke oder das Saugen von durch die Netzwerk- und Serverschränke erwärmter Luft über die Öffnung ermöglicht.

2. Modul nach Anspruch 1, wobei das Modul vorgesehen ist, damit die Luftumlaufleitung (1300) durch Aneinanderfügung von identischen Modulen (10A) gebildet wird, die in einer Reihe entlang ihrer Tiefe auf einer einzigen Reihe von Modulen angeordnet sind.

3. Modul nach Anspruch 1, wobei das Modul vorgesehen ist, damit die Luftumlaufleitung (1300) durch Aneinanderfügung von identischen Modulen (10A) gebildet wird, die in einer Reihe entlang ihrer Tiefe in zwei Reihen von untereinander zusammengebauten Modulen Seite an Seite angeordnet sind.

4. Modul nach einem der Ansprüche 1 bis 3, wobei das Modul vorgesehen ist, damit die Luftumlaufleitung (1300) durch Aneinanderfügung von identischen Modulen (10A) gebildet wird, die mit der Decke eines Raumes zusammenwirkend in einer Reihe angeordnet sind.

5. Modul nach einem der Ansprüche 1 bis 4, wobei die Seite des Moduls, die sich jenseits der Schrankreihe erstreckt, einen Teil umfasst, der dazu bestimmt ist, eine Einschließungsdecke eines Gangs (C) zu bilden, der zwischen der Schrankreihe und einer anderen parallelen Reihe von Schränken oder einer Trennwand gebildet ist, die gegebenenfalls eine Mauer eines Raumes bildet, gegebenenfalls mit den Modulen zusammenwirkend, die in einer Reihe auf dem Oberteil der Netzwerk- und Serverschräke der anderen Reihe zusammengebaut sind, wobei die Öffnung vorzugsweise in einem Bereich gebildet ist, der Teil der Decke ist, die zwischen den zwei Schrankreihen gebildet ist.

6. Modul nach einem der Ansprüche 1 bis 5, das eine Struktur und Abmessungen umfasst, die das Zusammenbauen der Module (10A) in einer Reihe auf dem Oberteil der Netzwerk- und Serverschränke (1000A) einer Reihe (A) ermöglicht, wobei eine erste und eine zweite Seite (12A; 120A) der Module sich auf beiden Seiten und über diese Reihe (A) von Netzwerk- und Serverschränken (100A) hinaus in Richtung einer ersten beziehungsweise einer zweiten Reihe von Netzwerk- und Serverschränken erstrecken, die dieser Reihe benachbart sind, um eine erste und eine zweite Decke zwischen dieser Reihe (A) und der ersten beziehungsweise der zweiten Reihe mit den Seiten der Module zusammenwirkend zu bilden, die in einer Reihe auf dem Oberteil der Netzwerk- und Serverschränke der ersten Reihe und der zweiten beziehungsweise der dritten Reihe zusammengebaut sind.

7. Modul nach einem der vorhergehenden Ansprüche, das mindestens einen Kabelwegteil auf einer Seite des Moduls umfasst, der dazu bestimmt ist, mit anderen Kabelwegteilen der in einer Reihe zusammengebauten Module einen Kabelweg zu bilden.

8. Modul nach einem der vorhergehenden Ansprüche, das eine untere Wand (16A; 160A) umfasst, die Teil der Decke ist, die zwischen den zwei Schrankreihen (A; B) gebildet ist, wobei die untere Wand (16A; 160A) eine Zugangsklappe (161A; 1610A) bildet, die es einem Benutzer ermöglicht, Zugang zum Inneren des Moduls zu erlangen, wenn die Module in einer Reihe auf dem Oberteil der Netzwerk- und Serverschränke zusammengebaut sind, die die Reihe bilden.

9. Modul nach einem der vorhergehenden Ansprüche, wobei die Tiefe des Moduls (10A) zwischen der Vorderseite und der Rückseite des Moduls zwischen 600 mm und 800 mm enthalten ist oder der Breite von mehreren Schränken entspricht, und wobei die Breite des Moduls (10A) zwischen den zwei Enden der Seiten des Moduls zwischen 1000 und 2400 mm, vorzugsweise zwischen 2000 und 2400 mm, enthalten ist.

10. Modul nach einem der vorhergehenden Ansprüche, das eine Lampe (162A; 1620A) aufweist, die an einem Bereich befestigt ist, der Teil der Decke ist, die zwischen den zwei Schrankreihen (A; B) gebildet ist, um den Gang (C) zu beleuchten, der durch die Decke eingeschlossen ist.

11. Einbau, der mindestens eine Baugruppe von Schränken und Modulen nach einem der vorhergehenden Ansprüche umfasst, wobei die Baugruppe Folgendes umfasst:
- eine Reihe (A) von aneinander angrenzenden Netzwerk- und Serverschränken, die eine Seite eines Ganges (C) bilden,
- eine Reihe von Modulen, die in einer Reihe auf der Reihe (A) von aneinander angrenzenden Netzwerk- und Serverschränken zusammengebaut sind,
wobei die Reihe von Modulen eine Seite umfasst, die sich jenseits der Fassaden der Netzwerk- und Serverschränke (100A) erstreckt, wobei die Reihe von Modulen mindestens einen Luftumlaufkanal (1300) bildet, der den Gang (C) gegebenenfalls mit einer zweiten Reihe von Modulen, die in einer Reihe auf dem Oberteil einer zweiten Reihe (B) von Netzwerk- und Serverschränken zusammengebaut sind, die die andere Seite des Ganges (C) bilden, oder mit der anderen Seite des Ganges (C) zusammenwirkend und gegebenenfalls mit einer Decke eines Raumes zusammenwirkend entlangführt, und
wobei die Öffnung (170A) von jedem Modul (10A) mehrere Öffnungen in dem Bereich bildet, der Teil der Decke des Ganges ist.

12. Einbau nach dem vorhergehenden Anspruch, wobei die Seite der Module, die sich jenseits der Fassaden der Netzwerk- und Serverschränke (100A) erstreckt, mindestens einen Teil einer Decke des Ganges (C) bildet.

13. Einbau nach Anspruch 11 oder 12, wobei die Modulreihe auf der Oberseite der Schrankreihe eine erste Leitung für den Umlauf von Kaltluft und eine zweite Leitung für den Umlauf von Warmluft bildet.

14. Einbau nach Anspruch 13, wobei die Anzahl von Baugruppen mindestens drei beträgt und wobei:
- die Netzwerk- und Serverschränke der zweiten Baugruppe die andere Seite des Ganges (C) bilden,
- die Reihen (A und F) von Netzwerk- und Serverschränken der ersten und der dritten Baugruppe einen anderen Gang (D) bilden,
- die Seiten (12A; 120A) der Modulreihe (10A) der ersten Menge, die mit einer Seite (12B; 120F) der Modulreihen der zweiten beziehungsweise der dritten Baugruppe zusammenwirken, eine entsprechende Decke für die Gänge bilden,
- die Modulreihen der ersten und der zweiten Baugruppe die erste Luftumlaufleitung (1300) bilden, und
- die Modulreihen der ersten und der dritten Baugruppe die zweite Luftumlaufleitung bilden, die den zweiten Gang (D) entlangführt.

15. Einbau nach Anspruch 14, der eine Klimaanlage umfasst, in der die erste Leitung (1300) mit dem Eingang der Klimaanlage (50) verbunden ist, um die Luft des ersten Ganges (C) über die Öffnungen (170A; 17B) zu saugen, die in der ersten Decke gebildet sind, und wobei die zweite Leitung mit dem Ausgang der Klimaanlage (50) verbunden ist, um Luft über die Öffnungen, die in der zweiten Decke gebildet sind, in den zweiten Gang (D) zu blasen.

16. Einbau nach einem der Ansprüche 11 bis 13, der eine Klimaanlage umfasst und wobei jedes Ende von jeder Leitung geschlossen ist oder mit einem Ausgang oder einem Eingang der Klimaanlage (50) verbunden ist.

## Claims

1. A module (10A) for forming in conjunction with other identical modules (10B; 10C) at least one air circulation duct (1300) by arranging the modules (10A) on top of computer cabinets (1000A) of one or two rows (A), the at least one air circulation duct formed being arranged to extend in the direction of the length of the one or more rows of computer cabinets, the computer cabinets (1000A) having standardized outside dimensions, a said module (10A) having a depth between the front and rear of the module and a width between two sides (12A, 120A) of the module allowing the modules (10A) to be arranged in succession in the sense of their depth on top of the computer cabinets (1000A) of a row with at least one of the two sides (12A, 120A) of the modules extending beyond the width of a said row of computer cabinets, wherein the module includes an opening (17A; 170A) emerging in the underside of the module, the air circulation duct (1300) formed by abutment of identical modules (10A) arranged in succession in the sense of the length of a row or two side-by-side rows of computer cabinets making it possible to deliver cooled air to the computer cabinets or extract air heated by the computer cabinets through said opening.

2. The module of claim 1, wherein the module is designed so that the duct for circulation of air (1300) is formed by abutment of identical modules (10A) arranged in succession in the sense of their depth in one single line of modules.

3. The module of claim 1, wherein the module is designed so that the duct for circulation of air (1300) is formed by abutment of identical modules (10A) arranged in succession in the sense of their depth in two rows of side-by-side modules assembled together.

4. The module according to any one of claims 1 to 3, wherein the module is designed so that the duct for circulation of air (1300) is formed by abutment of identical modules (10A) arranged in a row in cooperation with the ceiling of a room.

5. The module according to any one of claims 1 to 4, wherein the module side extending beyond the rack row comprises a portion for forming a containment ceiling of a corridor (C) formed between the cabinet row and another parallel row of cabinets or a partition optionally forming a wall of a room, possibly in cooperation with the modules arranged in succession on top of the computer cabinets of the other row, the opening being preferably formed in an area participating in the ceiling formed between the two rows of cabinets.

6. The module according to any of claims 1 to 5 comprising a structure and dimensions allowing assembly of the modules (10A) in a row on top of the computer cabinets (1000A) of one row (A) with a first and a second side (12A; 120A) of the modules extending at both sides beyond this row (A) of computer cabinets (100A) towards a respective first and second row of computer cabinets adjacent to that row to form a first and a second ceiling between this row (A) and, respectively, the first and second rows in cooperation with the sides of the modules arranged in succession on top of the computer cabinets of the first row and respectively the second and third rows.

7. The module according to any of the preceding claims, comprising at least a portion of a cable channel at one side of the module for forming, together with other cable channel portions of the modules arranged in succession, a cable channel.

8. The module according to any of the preceding claims, comprising a bottom wall (16A; 160A) participating in the ceiling formed between the two rows (A; B) of cabinets, the bottom wall (16A; 160A) forming an access hatch (161A, 1610A) for allowing a user to access the inside of the module when the modules are arranged in succession on top of the computer cabinets forming the row.

9. The module according to any preceding claim, wherein the depth of the module (10A) between the front and rear of the module is between 600 mm and 800 mm or corresponds to the width of several cabinets and wherein the width of the module (10A) between the two ends of the sides of the module is between 1000 and 2400 mm, preferably between 2000 and 2400 mm.

10. The module according to any preceding claim, comprising a lamp (162A, 1620A) fixed at an area participating in the ceiling formed between the two rows (A; B) of cabinets for illuminating the corridor (C) confined by the ceiling.

11. An installation comprising at least one set of cabinets and modules according to any one of the preceding claims, the set comprising:
- a row (A) of adjacent computer cabinets forming a side section of a corridor (C),
- a row of modules arranged in succession on the row (A) of adjacent computer cabinets,
wherein the row of modules includes a side extending beyond the fronts of the computer cabinets (100A), wherein the row of modules form at least one duct for circulation of air (1300) running along the corridor (C) optionally in cooperation with a second row of modules arranged in succession on top of a second row (B) of computer cabinets forming the other side section of the corridor (C) or with another side section of the corridor (C) and optionally in cooperation with a ceiling of a room, and
wherein the opening (170A) of each module (10A) form a plurality of openings in the area participating in the ceiling of the corridor.

12. Installation according to the preceding claim, wherein the side of the modules extending beyond the fronts of the computer cabinets (100a) forms at least a part of the ceiling of a corridor (C).

13. Installation according to claim 11 or 12, wherein the row of modules form above the row of cabinets a first duct for circulation of cold air and a second duct for circulation of hot air.

14. Installation according to claim 13, wherein the number of sets is at least three and wherein:
- the computer cabinets of the second set form the other side section of the corridor (C),
- the rows (A and F) of the computer cabinets of the first and third sets form another corridor (D),
- the sides (12A; 120A) of the row of modules (10A) of the first set respectively cooperate with a side (12B; 120F) of the module rows of the second and third sets forming a respective ceiling for the corridors,
- the module rows of the first and second sets form the first duct (1300) for circulation of air, and
- the module rows of the first and third sets form the second duct for circulation of air running along the second corridor (D).

15. Installation according to claim 14 comprising an air conditioning unit, wherein the first duct (1300) is connected to the inlet of the air conditioning unit (50) for drawing in air from the first corridor (C) through the openings (170A, 17B) formed in the first ceiling and wherein the second duct is connected to the outlet of the air conditioning unit (50) for blowing air into the second corridor (D) via the openings formed in the second ceiling.

16. Installation according to any one of claims 11 to 13, comprising an air conditioning unit and wherein each end of each duct is closed or is connected to an outlet or an inlet of the air conditioning unit (50).
